# EUROPÄISCHE PATENTANMELDUNG

(11) **EP 3 644 697 A1**
(43) Veröffentlichungstag der Anmeldung: **29.04.2020**
(21) Anmeldenummer: 19197158.9
(22) Anmeldetag: 13.09.2019
(51) Int. Cl.: H05K 7/20, F28F 27/02, G05D 23/08

(54) **KÜHLMODUL FÜR EIN FAHRZEUG-STEUERGERÄT, FAHRZEUG-STEUERGERÄT MIT EINEM KÜHLMODUL UND VERFAHREN ZUR WASSERKÜHLUNG EINES FAHRZEUG-STEUERGERÄTS**

(30) Priorität: 22.10.2018 DE 102018218049
(71) Anmelder: ZF Friedrichshafen AG, 88046 Friedrichshafen (DE)
(72) Erfinder: Rakoczi, Viktor, 88090 Immenstaad am Bodensee (DE)
(74) Vertreter: ZF Friedrichshafen AG

(57) **Zusammenfassung**

Kühlmodul (10) für ein Fahrzeug-Steuergerät (20) umfassend einen Kühlkörper (11), Anschlüsse (12a, 12b), um ein Kühlmittel durch den Kühlkörper (11) zu leiten, eine in dem Kühlkörper (11) angeordnete Turbulenzeinlage umfassend wenigstens erste Kühlrippen (13a, 13b), und wenigstens ein erstes in dem Kühlkörper (11) angeordnetes Bimetall (14a, 14b), wobei das wenigstens erste Bimetall (14a, 14b) angeordnet ist, die wenigstens ersten Kühlrippen (13a, 13b) in Abhängigkeit einer Temperatur abhängigen Formveränderung des wenigstens ersten Bimetalls (14a, 14b) zu verstellen. Ferner bezieht sich die Erfindung auf ein Fahrzeug-Steuergerät (20) mit einem Kühlmodul (10) und ein Verfahren zur Wasserkühlung eines Fahrzeug-Steuergeräts (20).

## Beschreibung

Die Erfindung bezieht sich auf ein Kühlmodul für ein Fahrzeug-Steuergerät nach Anspruch 1. Ferner bezieht sich die Erfindung auf ein Fahrzeug-Steuergerät nach Anspruch 7 mit einem Kühlmodul. Außerdem bezieht sich die Erfindung auf ein Verfahren nach Anspruch 10 zur Wasserkühlung eines Fahrzeug-Steuergeräts.

Aus dem Stand der Technik sind ferner Fahrzeug-Steuergeräte, im Englischen electronic control unit, abgekürzt ECU, bekannt. Fahrzeug-Steuergeräte umfassen Hardware-Plattformen zur logischen Verarbeitung von Eingangssignalen, um Logik- und/oder Leistungspegel als Regel-oder Steuersignale für die Fahrzeugsteuerung bereitzustellen. Fahrzeug-Steuergeräte, die Fahrerassistenzsysteme und/oder automatisiertes/autonomes Fahren regeln und steuern, umfassen im derzeitigen Stand der Technik supercomputing Hardware-Plattformen. Diese supercomputing Plattformen umfassen Mehrkernprozessoren umfassend mehrere zentrale Prozessoreinheiten und mehrere Grafikprozessoren. Bei einem Mehrkernprozessor sind mehrere Kerne auf einem einzigen Chip, das heißt einem Halbleiterbauelement, angeordnet. Mehrkernprozessoren erreichen eine höhere Rechenleistung und sind kostengünstiger in einem Chip zu implementieren im Vergleich zu Mehrprozessorsystemen, bei denen jeder einzelne Kern in einem Prozessorsockel angeordnet ist und die einzelnen Prozessorsockel auf einer Hauptplatine angeordnet sind. Die Mehrkernprozessoren prozessieren eine künstliche Intelligenz, zum Beispiel künstliche neuronale Netzwerke, um vorzugsweise intuitiv auf neue Fahrsituationen wie ein menschlicher Fahrer reagieren zu können. Dies wird realisiert mittels einer großen Rechenleistung. Dabei entsteht viel Wärme, die durch Kühlung abzuführen ist. Wasser ist wegen seiner hohen spezifischen Wärmekapazität ein besonders geeignetes Kühlmittel für Fahrzeug-Steuergeräte.

Eine Anforderung an Fahrzeug-Steuergeräte ist eine Funktionalität im Temperaturbereich von im Wesentlichen -40°C bis +9x°C. Wasser hat aber eine geringe Kältetauglichkeit. In der Regel wird dem Kühlmittel Wasser Ethylenglykol zugesetzt, um in Abhängigkeit des Volumenanteils von Ethylenglykol einen Eisflockenpunkt des Wasser-Ethylenglykols-Gemisches herabzusetzen. Allerdings ist bei einer Temperatur von - 40°C hierfür ein Ethylenglykol Volumenanteil von über 50% erforderlich. Dieser hohe Ethylenglykol-Anteil führt jedoch nachteilig zu einer hohen Abhängigkeit zwischen Temperatur und Viskosität des Kühlmittels. Mit sinkender Temperatur, insbesondere unter -10 °C, wird das Kühlmittel dickflüssiger, die Viskosität nimmt zu. Dies führt zu einem unerwünschten Volumenstromabfall und Druckzunahme. Die Kühlung ist nicht performant. Eine Kompensation dieser fluidmechanischen Kenngrößen Volumenstrom und Druck wäre mit einer leistungsstärkeren Kühlpumpe zu bewältigen. Dies wäre jedoch mit zusätzlichem Aufwand und Kosten verbunden.

Hier setzt die Erfindung an. Der Erfindung hat die Aufgabe zugrunde gelegen, die Kühlung von Fahrzeug-Steuergeräten zu verbessern.

Die Erfindung löst diese Aufgabe durch ein Kühlmodul für ein Fahrzeug-Steuergerät mit den Merkmalen des Anspruchs 1. Ferner löst die Erfindung die Aufgabe durch ein Fahrzeug-Steuergerät mit den Merkmalen des Anspruchs 7. Außerdem löst die Erfindung die Aufgabe durch ein Verfahren zur Wasserkühlung eines Fahrzeug-Steuergeräts mit den Merkmalen des Anspruchs 10.

Weiterbildungen und vorteilhafte Ausgestaltungen sind in den Unteransprüchen angegeben.

Das erfindungsgemäße Kühlmodul für ein Fahrzeug-Steuergerät umfasst einen Kühlkörper. Ferner umfasst das Kühlmodul Anschlüsse, um ein Kühlmittel durch den Kühlkörper zu leiten. Außerdem umfasst das Kühlmodul eine in dem Kühlkörper angeordnete Turbulenzeinlage. Die Turbulenzeinlage umfasst wenigstens erste Kühlrippen. Das Kühlmodul umfasst des Weiteren wenigstens ein erstes in dem Kühlkörper angeordnetes Bimetall. Das Bimetall ist angeordnet, die wenigstens ersten Kühlrippen in Abhängigkeit einer Temperatur abhängigen Formveränderung des wenigstens ersten Bimetalls zu verstellen.

Kühlmodule sind Baueinheiten, die aus verschiedenen Komponenten zur Kühlung eines Geräts, zum Beispiel eines Fahrzeug-Steuergeräts, bestehen, wobei die Komponenten hinsichtlich der zu kühlenden Geräte und des gegebenen Bauraums entsprechend dimensioniert sind. Zum Beispiel besitzt der Kühlkörper eine Länge von 210 mm und eine Breite von 140 mm. Die Anschlüsse sind vorzugsweise ein Einlass und ein Auslassventil. Das Einlassventil ist an einer Einlassseite des Kühlkörpers angeordnet. Das Auslassventil ist an einer der Einlassseite gegenüberliegende Auslassseite des Kühlkörpers angeordnet. Bei dieser Anordnung durchströmt das Kühlmittel den Kühlkörper im Wesentlichen geradlinig. Alternativ sind Einlassventil und Auslassventil an einer Seite des Kühlkörpers angeordnet. Bei dieser Anordnung durchströmt das Kühlmittel den Kühlkörper im Wesentlichen U-förmig. Das Kühlmittel ist vorzugsweise ein Wasser-Ethylenglykol-Gemisch. Eine weitere Komponente des Kühlmoduls sind die Kühlrippen zur Verbesserung des Wärmeübertrags. Die Kühlrippen oder zusätzliche Komponenten des Kühlmoduls bilden Turbulenzeinlagen zur Verwirbelung des Kühlmittels. Die Kühlrippen sind aus Metall, zum Beispiel Aluminium und/oder Kupfer.

Ein Bimetall umfasst zwei Metalle mit unterschiedlichen Längenausdehnungskoeffizienten. Die zwei Metalle sind miteinander stoffschlüssig oder formschlüssig verbunden. Verbindet man die beiden Enden der zwei Metalle, zum Beispiel durch Nieten, punktuelles Schweißen oder Walzen, führt die Temperatur abhängige unterschiedliche Verlängerung zu einer Verbiegung des Bimetalls. Die Temperatur abhängige Verbiegung des Bimetalls und die Kontaktierung des Bimetalls an die Kühlrippen ergibt im Resultat, dass das Bimetall als Aktor für die Verstellung der Kühlrippen dient. Das Bimetall wirkt zusammen mit den Kühlrippen ähnlich einer Membran oder eines Ventils in Bezug auf das Kühlmittel. Bei niedrigen Temperaturen verbiegt sich das Bimetall und verformt die Kühlrippen. Insbesondere drückt das Bimetall die Kühlrippen in Richtung Gehäusewand des Kühlkörpers. Damit ist das Ventil offen. Bei hohen Temperaturen nimmt das Bimetall einen geradlinigen, ebenen Zustand ein. Die Kühlrippen werden im Wesentlichen vollständig in den Durchlasskanal des Kühlmittels gezogen. Damit ist das Ventil geschlossen. Die Strömung des Kühlmittels wird auf eine spezifizierte Größe begrenzt. Durch entsprechende Wahl der Metalle des Bimetalls wird ein im Wesentlichen konstanter Volumenstrom und konstanter Druckverlust in dem Kühlkörper über einen Temperaturbereich von -40°C bis +9x°C bereitgestellt. Damit wird eine dynamische Turbulenzeinlage realisiert, durch die ein Verklumpen des Kühlmittels bei tiefen Temperaturen, insbesondere unter -10°C, vermieden wird. Insgesamt wird durch das Bimetall die Kühlperformanz des Kühlmoduls verbessert. Das Bimetall hat insbesondere den Vorteil, dass es große Kräfte erzeugt. Die relativ großen Massen der Kühlrippen sind damit verstellbar und zugleich die damit verbundene Reibung überwindbar. Ein weiterer Vorteil des Bimetalls ist dessen Langlebigkeit aufgrund verschleißarmer Funktionsweise und dessen Eignung als Wärmeleitmedium. Das Bimetall wird vorzugsweise an einem Gehäuserand des Kühlkörpers derart thermisch ankontaktiert, dass die Wärmeleitfähigkeit möglichst gut ist. Dies kann eine Metall zu Metall Verbindung sein, vorzugsweise eine angeschweißte Lösung. So verläuft der Wärmestrom nicht nur durch das Kühlfluid, sondern auch über das Gehäuse.

Vorzugsweise sind die wenigstens ersten Kühlrippen quer zu der Längsrichtung des Kühlkörpers angeordnet. Die Mittelachse des wenigstens ersten Bimetalls ist parallel zu der Längsrichtung des Kühlkörpers angeordnet. Beide Seiten des wenigstens ersten Bimetalls sind neben der Mittelachse mit dem Kühlkörper verbunden. Jeweils ein erstes Ende der ersten Kühlrippen ist mit einer ersten Seite oder einer der ersten Seite gegenüberliegender zweiter Seite des Kühlkörpers verbunden. Ein zweites Ende der ersten Kühlrippen ist an dem ersten Bimetall angeordnet zum Verstellen der ersten Kühlrippen durch temperaturabhängiges Verbiegen des ersten Bimetalls. Die erste Seite des Kühlkörpers ist vorzugsweise dessen Unterseite. Die zweite Seite des Kühlkörpers ist vorzugsweise dessen Oberseite. Das zweite Ende der ersten Kühlrippen liegt lose auf dem ersten Bimetall auf, gleitet auf dem ersten Bimetall oder ist mit dem ersten Bimetall zum Beispiel vernietet oder verschweißt. Mit dieser Anordnung ist es möglich, die Kühlrippen durch Verbiegen des Bimetalls einfach und mit hoher Präzision zu verstellen. Beispielsweise bewirkt eine Ausdehnung im Zehntelmillimeter-Bereich bis Millimeter-Bereich quer der Strömungsrichtung des Kühlmittels einen deutlich größeren Verstellweg in vertikaler Richtung, also in Richtung der Ober- bzw. Unterseite des Kühlkörpers.

In einer weiteren Ausführung der Erfindung umfasst das Kühlmodul zweite Kühlrippen. Die zweiten Kühlrippen sind quer zu der Längsrichtung des Kühlkörpers angeordnet sind. Ferner umfasst das Kühlmodul ein zweites in dem Kühlkörper angeordnetes Bimetall. Das zweite Bimetall ist parallel zu dem ersten Bimetall angeordnet ist. Jeweils ein erstes Ende der zweiten Kühlrippen ist mit der zweiten Seite oder der ersten Seite des Kühlkörpers verbunden. Ein zweites Ende der zweiten Kühlrippen ist an dem zweiten Bimetall angeordnet analog zu den ersten Kühlrippen, zum Verstellen der zweiten Kühlrippen durch temperaturabhängiges Verbiegen des zweiten Bimetalls. Die ersten Kühlrippen sind beispielsweise mit der Unterseite des Kühlkörpers verbunden. Die zweiten Kühlrippen sind beispielsweise mit der Oberseite des Kühlkörpers verbunden. Zwischen den ersten Kühlrippen und den zweiten Kühlrippen sind das erste Bimetall und das zweite Bimetall, vorzugsweise zentriert im Kühlkörper, angeordnet. Damit kann der Volumenstrom des Kühlmittels verbessert werden.

Das erste Bimetall verbiegt sich entgegengesetzt zu dem zweiten Bimetall. Bei tiefen Temperaturen drückt das erste Bimetall beispielsweise die ersten Kühlrippen in Richtung Unterseite des Kühlkörpers. Das zweite Bimetall drückt beispielsweise die zweiten Kühlrippen in Richtung Oberseite des Kühlkörpers bei tiefen Temperaturen.

Vorteilhafterweise sind die ersten Kühlrippen und/oder die zweiten Kühlrippen jeweils an ihrem ersten Ende mit dem Kühlkörper verschweißt oder vernietet.

Die ersten Kühlrippen und/oder die zweiten Kühlrippen sind bevorzugt wellenförmig ausgestaltet sind. Damit wird die Verwirbelung des Kühlmittels verbessert und die Oberfläche der ersten Kühlrippen und/oder der zweiten Kühlrippen vergrößert.

Das erste Bimetall und/oder das zweite Bimetall besitzen bevorzugt die Form eines Bleches oder sind besonders bevorzugt lamellenförmig ausgestaltet. Die lamellenförmige Ausgestaltung verbessert die Verstellbarkeit der ersten Kühlrippen und/oder der zweiten Kühlrippen. Damit wird der Kühlvorgang verbessert.

Erfindungsgemäß umfasst ein Fahrzeug-Steuergerät ein erfindungsgemäßes Kühlmodul. Das Fahrzeug-Steuergerät ist vorzugsweise eine AD/ADAS Domain ECU mit künstlicher Intelligenz, das heißt ein Fahrzeug-Steuergerät für Fahrerassistenzsystem, im Englischen advanced driver assistance systems genannt, oder für automatisierte oder autonome Fahrfunktionen, im Englischen automated or autonomous driving genannt. Domain bedeutet, dass das Fahrzeug-Steuergerät den gesamten Bereich für ADAS/AD steuert, insbesondere die Umfelderfassung durch Umfeldsensoren wie Kamera, Radar, Lidar, Ultraschall, Mikrofone, das Ableiten einer realen Fahrsituation, die Trajektorienplanung und die Fahrzeugführung. Die Hardware-Plattform des Fahrzeug-Steuergeräts ist ausgeführt, die Eingangssignale mittels künstlicher Intelligenz zu verarbeiten. Hierzu umfasst die Hardware-Plattform insbesondere Grafikprozessoren, die für parallel computing ausgelegt sind, vorzugsweise in Form von Mehrkernprozessoren.

Das Kühlmodul ist vorzugsweise an das Fahrzeug-Steuergerät angeflanscht, um einen Wärmeübertrag sicherzustellen.

Vorteilhafterweise ist zwischen dem Fahrzeug-Steuergerät und dem Kühlmodul ein Wärmeleiter zur Verbesserung des Wärmeübertrags. Der Wärmeleiter ist beispielsweise eine weitere Komponente des Kühlmoduls. Insbesondere kann der Wärmeleiter ein sogenannter Wärmespreizer sein, mit der Aufgabe die Wärmestromdichte über eine größere Fläche zu verkleinern, zum Beispiel von 23 x 23mm großen Fläche auf eine Handflächengroße. Ein Wärmespreizer ist ein thermo-mechanisches Bauteil, durch dessen spezielle Geometrie die Wärmestromdichte einer Wärmequelle zur Wärmesenke mittels eines wärmehochleitfähigen Körpers, zum Beispiel umfassend Aluminium oder Kupfer, reduziert wird. Im einfachsten Fall ist dieser Körper mit einer auf den Kopf gestellten Pyramide vergleichbar. Auf der unteren Spitze ist die Wärmequelle, auf der oberseitigen Fläche ist die Wärmesenke.

Die Leistungsfähigkeit bei sogar größer werdender Packungsdichte von Halbleitern, insbesondere von GPUs, nimmt stetig zu, sodass mit konventionellen Kühlkonzepten eine adäquate Kühlung nicht mehr zu bewerkstelligen ist. Der Wärmeleiter ist vorzugsweise mit der ersten Seite des Kühlkörpers vernietet oder verschweißt. Die ersten Kühlrippen sind ebenfalls mit der ersten Seite des Kühlkörpers vernietet oder verschweißt. Durch das Vernieten oder Verschweißen des Wärmeleiters und der ersten Kühlrippen ist der Wärmeübergang besser als über eine lose schleifende Verbindung.

Das Kühlmodul oder das Fahrzeug-Steuergerät sind beispielsweise in einem Kühlkreislauf eines Fahrzeuges integriert, in den auch weitere Fahrzeugkomponenten und/oder weitere Steuergeräte integriert sind. Durch die erfindungsgemäße Turbulenzeinlage mit Bimetall, die eine performante Kühlung ohne Verklumpen des Kühlmittels bereitstellt, wird der Kühlkreislauf gegen Ausfälle gesichert. Damit wird die Systemverfügbarkeit verbessert und eine Beeinträchtigung der weiteren Fahrzeugkomponenten und/oder weiteren Steuergeräte zumindest reduziert.

Das Kühlmodul und/oder das Fahrzeug-Steuergerät sind vorzugsweise in einem Gehäuse angeordnet. Das Gehäuse schützt das Kühlmodul vor mechanischen Beanspruchungen, Wettereinflüssen und weiteren äußeren Einflüssen.

Das erfindungsgemäße Verfahren zur Wasserkühlung eines Fahrzeug-Steuergeräts umfasst die Verfahrensschritte
- Leiten eines Kühlmittels durch ein Kühlmodul, wobei das Kühlmodul ein erfindungsgemäßes Kühlmodul ist und in Wärmekontakt mit dem Fahrzeug-Steuergerät ist,
- Erzeugen einer turbulenten Strömung des Kühlmittels durch das Kühlmodul mittels einer Turbulenzeinlage und
- Ändern des Volumenstroms des Kühlmittels durch das Kühlmodul.

Mit dem Verfahren wird eine Wasserkühlung mit im Wesentlichen konstanten Volumenstrom und konstanten Druckverlust im Temperaturbereich von -40°C bis +9x°C erreicht. Eine Verklumpung des Kühlmittels bei tiefen Temperaturen, insbesondere unter -10°C, wird vermieden.

Die Erfindung wird in den Ausführungsbeispielen verdeutlicht. Es zeigen:
Fig. 1 Querschnitt eines Ausführungsbeispiels eines erfindungsgemäßen Kühlmoduls,
Fig. 2 das Ausführungsbeispiel der Fig. 1 entlang der Schnittlinie I,
Fig. 3 ein Ausführungsbeispiel eines erfindungsgemäßen Kühlmoduls in einer Grundstellung zweier Bimetalle,
Fig. 4 das Ausführungsbeispiel der Fig. 3 bei einer verbogenen Stellung der Bimetalle und
Fig. 5 ein Ausführungsbeispiel eines erfindungsgemäßen Verfahrens.

In den Figuren bezeichnen gleiche Bezugszeichen gleiche oder funktionsähnliche Teile. Übersichthalber werden in den einzelnen Figuren nur die jeweils relevanten Teile hervorgehoben.

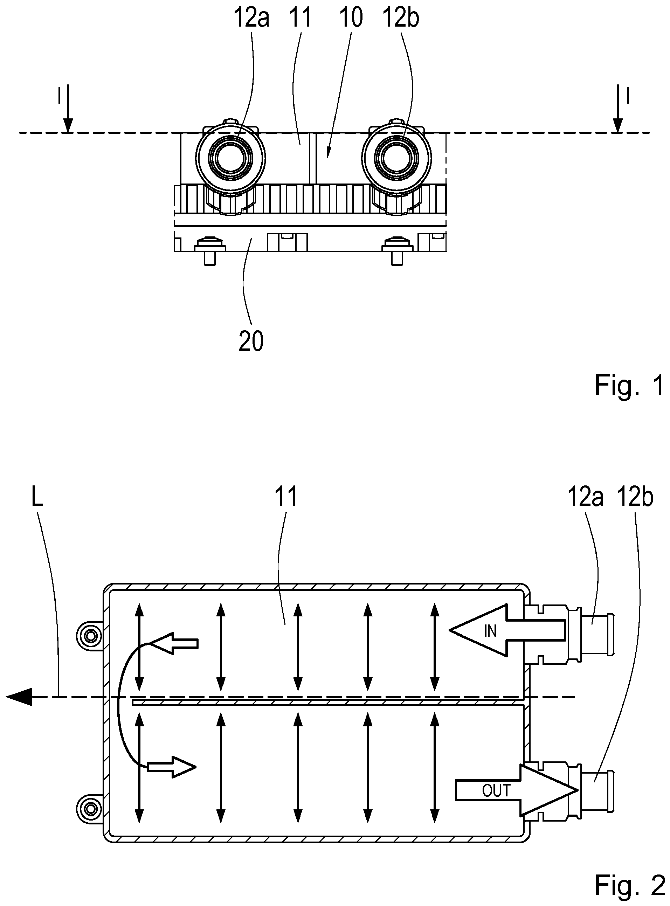

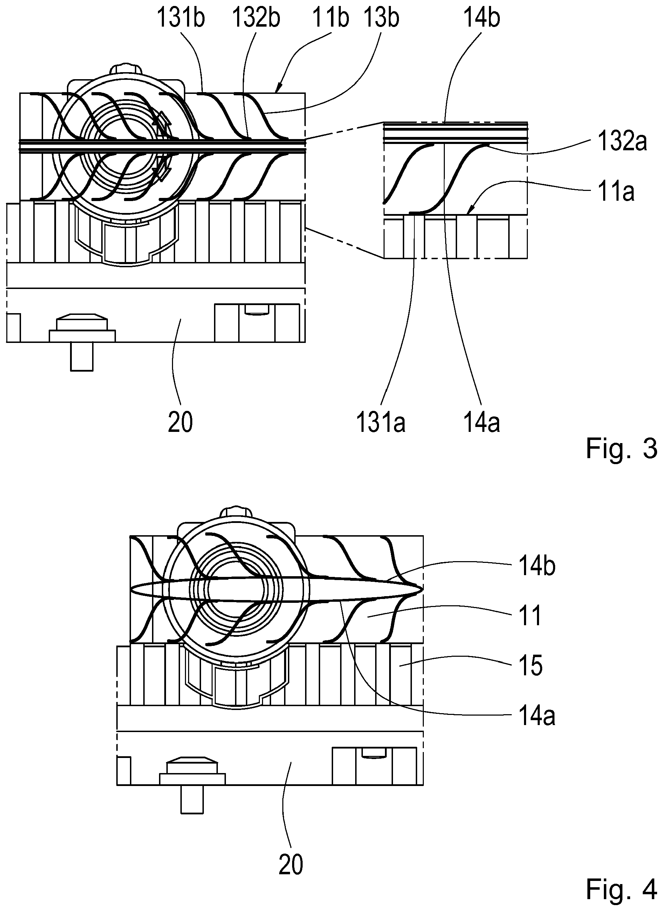

Das Kühlmodul 10 in Fig. 1 umfasst einen Kühlkörper 11. Der Kühlkörper 11 besitzt eine erste Seite 11a. Die erste Seite 11a ist beispielsweise eine Unterseite des Kühlkörpers 11, vergleiche Fig. 3. Ferner besitzt der Kühlkörper 11 eine zweite Seite 11b. Die zweite Seite 11b ist beispielsweise eine Oberseite des Kühlkörpers 11, vergleiche Fig. 3. Durch den Kühlkörper 11 wird ein Kühlmittel geleitet. Das Kühlmittel ist beispielsweise ein Wasser-Ethylenglykol-Gemisch. Der Kühlkörper 11 bildet beispielsweise Kanäle aus, durch die das Kühlmittel geleitet wird.

In Fig. 2 ist exemplarisch ein U-förmiger Kanal dargestellt. Im Bereich des ersten Anschlusses 12a und/oder des zweiten Anschluss 12b sind alternativ zusätzliche Kanäle oder abstehende Zapfen angebracht zur zielgerichteten Leitung des Kühlmittels durch den Kühlkörper 11 oder zu Homogenisierung des Kühlmittels in dem Kühlkörper 11. Die in Fig. 2 dargestellten bidirektionalen Pfeile innerhalb des Kühlkörpers 11 verdeutlichen die Ausdehnungsrichtung eines ersten Bimetalls 14a und eines zweiten Bimetalls 14b zwischen den jeweils fest vernieteten oder verschweißten Endpunkte derselben, siehe auch Fig. 3. Das Kühlmodul 10 umfasst einen ersten Anschluss 12a. Über den ersten Anschluss 12a wird das Kühlmittel in den Kühlkörper 11 geleitet. Der erste Anschluss 12a ist als ein Einlassventil ausgeführt. Das Kühlmodul 10 umfasst einen zweiten Anschluss 12b. Über den zweiten Anschluss 12b wird das Kühlmittel aus dem Kühlkörper 11 geleitet. Der zweite Anschluss 12b ist als ein Auslassventil ausgeführt.

Das Kühlmodul 10 ist in den Figuren auf ein Fahrzeug-Steuergerät 20 aufgeflanscht, wobei zwischen dem Kühlmodul 10 und dem Fahrzeug-Steuergerät 20 ein Wärmeleiter 15 angeordnet ist.

Fig. 3 zeigt erste Kühlrippen 13a und zweite Kühlrippen 13b. Die ersten Kühlrippen 13a und die zweiten Kühlrippen 13b sind übereinander angeordnet und besitzen jeweils eine Wellen- oder S-Form, wobei die Form der zweiten Kühlrippen 13b vertikal gespiegelt ist relativ zu der Form der ersten Kühlrippen 13a. Die ersten Kühlrippen 13a sind mit einem ersten Ende 131a an der ersten Seite 11a des Kühlkörpers 11 beispielsweise verschweißt und gleiten mit einem zweiten Ende 132a auf einem ersten Bimetall 14a. Die zweiten Kühlrippen 13b sind mit einem ersten Ende 131b an der zweiten Seite 11b des Kühlkörpers 11 beispielsweise verschweißt und gleiten mit einem zweiten Ende 132b auf einem zweiten Bimetall 14b. Die Anordnung der ersten Kühlrippen 13a, zweiten Kühlrippen 13b, des ersten Bimetalls 14a und des zweiten Bimetalls 14b bildet aufgrund der Temperatur abhängigen Verbiegung des ersten Bimetalls 14a und des zweiten Bimetalls 14b ein Ventil. In Fig. 3 ist das Ventil geschlossen. Dies entspricht dem Zustand bei Temperaturen oberhalb eines Schwellenwertes. In Fig. 4 ist das Ventil offen. Dies entspricht dem Zustand bei Temperaturen unterhalb des Schwellenwertes. Der Schwellenwert ist zum Beispiel -10°C.

Wenn das durch das erste Bimetall 14a und das zweite Bimetall 14b gebildete Ventil offen ist, siehe Fig. 4, erfolgt die Wärmeabfuhr des Fahrzeugsteuergeräts 20 an das Kühlmittel über den Wärmeleiter 15 nur über das erste Bimetall 14a und die ersten Kühlrippen 13a, nicht jedoch über das zweite Bimetall 14b mit den zweiten Kühlrippen 13b. Bei niedrigen Temperaturen wird noch kein hochperformanter Wärmeabtrag gefordert.

In Fig. 3. jedoch, wenn das erste Bimetall 14a und das zweite Bimetall 14b planarbündig gegenüberliegen, dann geschieht der Wärmeübergang zusätzlich auch von dem ersten Bimetall 14a an das direkt benachbarte zweite Bimetall 14b. Damit wird mehr Fläche für den Wärmeabtrag bereitgestellt und der Wärmeabtrag damit verbessert.

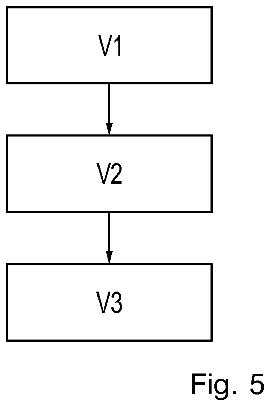

Fig. 5 symbolisiert das erfindungsgemäße Verfahren zur Wasserkühlung des Fahrzeug-Steuergeräts 20. In einem ersten Verfahrensschritt V1 wird das Kühlmittel durch das Kühlmodul 10 geleitet. Das Kühlmodul 10 ist in Wärmekontakt mit dem Fahrzeug-Steuergerät 20. In einem zweiten Verfahrensschritt V2 wird eine turbulente Strömung des Kühlmittels durch das Kühlmodul 10 mittels der Turbulenzeinlage erzeugt. In einem dritten Verfahrensschritt V3 wird der Volumenstrom des Kühlmittels durch das Kühlmodul 10 durch die Formveränderung des ersten Bimetalls 14a und des zweiten Bimetalls 14b verändert in Abhängigkeit der Temperatur.

### Bezugszeichen

- 10: Kühlmodul
- 11: Kühlkörper
- 11a: erste Seite
- 11b: zweite Seite
- 12a: Anschluss
- 12b: Anschluss
- 13a: Kühlrippe
- 131a: erstes Ende
- 132a: zweites Ende
- 13b: Kühlrippe
- 131b: erstes Ende
- 132b: zweites Ende
- 14a: Bimetall
- 14b: Bimetall
- 15: Wärmeleiter
- 20: Fahrzeug-Steuergerät
- L: Längsrichtung
- V1-V3: Verfahrensschritte
- I: Schnittlinie

## Patentansprüche

1. Kühlmodul (10) für ein Fahrzeug-Steuergerät (20) umfassend
• einen Kühlkörper (11),
• Anschlüsse (12a, 12b), um ein Kühlmittel durch den Kühlkörper (11) zu leiten,
• eine in dem Kühlkörper (11) angeordnete Turbulenzeinlage umfassend wenigstens erste Kühlrippen (13a, 13b), und
• wenigstens ein erstes in dem Kühlkörper (11) angeordnetes Bimetall (14a, 14b),
wobei das wenigstens erste Bimetall (14a, 14b) angeordnet ist, die wenigstens ersten Kühlrippen (13a, 13b) in Abhängigkeit einer Temperatur abhängigen Formveränderung des wenigstens ersten Bimetalls (14a, 14b) zu verstellen.

2. Kühlmodul (10) nach Anspruch 1, wobei
• die wenigstens ersten Kühlrippen (13a, 13b) quer zu der Längsrichtung (L) des Kühlkörpers (11) angeordnet sind, und
• die Mittelachse des wenigstens ersten Bimetalls (14a, 14b) parallel zu der Längsrichtung (L) des Kühlkörpers (11) angeordnet ist und beide Seiten des wenigstens ersten Bimetalls (14a, 14b) neben der Mittelachse mit dem Kühlkörper (11) verbunden sind,
wobei jeweils ein erstes Ende (131a, 131b) der ersten Kühlrippen (13a, 13b) mit einer ersten Seite (11a) oder einer der ersten Seite (11a) gegenüberliegender zweiter Seite (11b) des Kühlkörpers (11) verbunden ist und ein zweites Ende (132a, 132b) der ersten Kühlrippen (13a, 13b) an dem ersten Bimetall (14a, 14b) angeordnet ist zum Verstellen der ersten Kühlrippen (13a, 13b) durch temperaturabhängiges Verbiegen des ersten Bimetalls (14a, 14b).

3. Kühlmodul (10) nach Anspruch 1 oder 2, umfassend
• zweite Kühlrippen (13b), die quer zu der Längsrichtung (L) des Kühlkörpers (11) angeordnet sind, und
• ein zweites in dem Kühlkörper (11) angeordnetes Bimetall (14b), das parallel zu dem ersten Bimetall (14a) angeordnet ist,
wobei jeweils ein erstes Ende (131b) der zweiten Kühlrippen (13b) mit der zweiten Seite (11b) oder der ersten Seite (11a) des Kühlkörpers (11) verbunden ist und ein zweites Ende (132b) der zweiten Kühlrippen (13b) an dem zweiten Bimetall (14b) angeordnet ist zum Verstellen der zweiten Kühlrippen (13b) durch temperaturabhängiges Verbiegen des zweiten Bimetalls (14b).

4. Kühlmodul (10) nach einem der vorangehenden Ansprüche, wobei die die ersten Kühlrippen (13a) und/oder die zweiten Kühlrippen (13b) jeweils an ihrem ersten Ende 131a, 131b) mit dem Kühlkörper (11) verschweißt oder vernietet sind.

5. Kühlmodul (10) nach einem der vorangehenden Ansprüche, wobei die ersten Kühlrippen (13a) und/oder die zweiten Kühlrippen (13b) wellenförmig ausgestaltet sind.

6. Kühlmodul (10) nach einem der vorangehenden Ansprüche, wobei das erste Bimetall (14a) und/oder das zweite Bimetall (14b) die Form eines Bleches besitzt oder lamellenförmig ausgestaltet ist.

7. Fahrzeug-Steuergerät (20) umfassend ein Kühlmodul (10) nach einem der Ansprüche 1 bis 6.

8. Fahrzeug-Steuergerät (20) nach Anspruch 7, wobei das Kühlmodul (10) an das Fahrzeug-Steuergerät (20) angeflanscht ist.

9. Fahrzeug-Steuergerät (20) nach Anspruch 7 oder 8, wobei zwischen dem Fahrzeug-Steuergerät (20) und dem Kühlmodul (10) ein Wärmeleiter (15) angeordnet ist.

10. Verfahren zur Wasserkühlung eines Fahrzeug-Steuergeräts (20) umfassend die Verfahrensschritte
• Leiten eines Kühlmittels durch ein Kühlmodul (10), wobei das Kühlmodul (10) ein Kühlmodul (10) nach einem der Ansprüche 1 bis 6 ist und in Wärmekontakt mit dem Fahrzeug-Steuergerät (20) ist (V1),
• Erzeugen einer turbulenten Strömung des Kühlmittels durch das Kühlmodul (10) mittels der Turbulenzeinlage (V2) und
• Ändern des Volumenstroms des Kühlmittels durch das Kühlmodul (10) (V3).
